# EUROPÄISCHE PATENTSCHRIFT

(11) **EP 3 516 758 B1**
(45) Veröffentlichungstag und Bekanntmachung des Hinweises auf die Patenterteilung: **14.07.2021**
(21) Anmeldenummer: 17844637.3
(22) Anmeldetag: 07.12.2017
(51) Int. Cl.: H02K 5/173, H02K 9/22, H02K 5/24, H02K 11/215, H02K 11/30

(54) **GEHÄUSE FÜR EINE ELEKTRISCHE MASCHINE MIT EINER KÜHLVORRICHTUNG**
HOUSING FOR AN ELECTRIC MACHINE WITH A COOLING DEVICE
CARTER POUR MACHINE ÉLECTRIQUE MUNI D'UN DISPOSITIF DE REFROIDISSEMENT

(30) Priorität: 20.12.2016 AT 511602016
(43) Veröffentlichungstag der Anmeldung: 31.07.2019
(73) Patentinhaber: MELECS EWS GmbH, 7011 Siegendorf (AT)
(72) Erfinder: NEUMANN, Gerhard, 3231 St. Margarethen (AT); HELLINGER, Leopold, 3710 Ziersdorf (AT); LEX, Manfred, 7350 Oberpullndorf (AT)
(74) Vertreter: Maier, Daniel Oliver
(86) Internationale Anmeldenummer: PCT/EP2017/081779
(87) Internationale Veröffentlichungsnummer: WO 2018/114349

(56) Entgegenhaltungen:
- EP-A2- 3 007 330
- JP-A- H11 356 006

## Beschreibung

Die Erfindung bezieht sich auf ein Gehäuse für eine elektrische Maschine mit einer Kühlvorrichtung.

Insbesondere in der Fahrzeugelektronik besteht häufig die Notwendigkeit, Geräte mit Steuerelektronik in einen Motor, in ein Getriebe oder in eine Pumpe etc. zu integrieren, um begrenzte Einbauräume möglichst gut zu nutzen und um Leitungswege kurz zu halten. Von beispielsweise mit Transistoren bestückten Trägerplatten abgegebene Wärme ist über Kühlvorrichtungen möglichst effektiv abzuführen.

Aus dem Stand der Technik ist die EP 2 429 273 A2 bekannt, in der eine Kühlvorrichtung für ein elektrisches Gerät beschrieben wird. Auf einer Trägerplatte ist eine elektronische Schaltung angeordnet. Zylindrische Anpress-Dome kontaktieren Verlustleistung erzeugende Elemente mechanisch und thermisch. Die Anpress-Dome sind zwischen Gehäuseinnenwänden und den Verlustleistung erzeugenden Elementen vorgesehen und pressen die Trägerplatte an eine Innenseite eines als Kühlkörper ausgeführten Gehäusedeckels. Über diesen Gehäusedeckel wird entstehende Wärme von den Verlustleistung erzeugenden Elementen an eine Umgebung abgeleitet.
Umlaufend auf der Trägerplatte angeordnete Anpress- und Kühlvorrichtungen sind in der EP 2 429 273 A2 nicht offenbart.

Weiterhin zeigt die US 2006/0082975 A1 ein Gehäuse für ein elektronisches Steuergerät, das eine Trägerplatte aufweist. Auf zwei Seiten der Trägerplatte sind jeweils entlang einer Geraden Transistoren, d.h. insgesamt zwei Transistor-Reihen angeordnet. Jede der beiden Transistor-Reihen wird über eine eigene zwischen dem Gehäuse und der jeweiligen Transistor-Reihe angeordnete Federplatte gegen die Trägerplatte gepresst. Unmittelbar unter jeder der beiden Transistor-Reihen ist auf der Trägerplatte je eine Kühlvorrichtung angeordnet. Die Trägerplatte liegt im Bereich dieser Kühlvorrichtungen auf Kühlkörpern auf.

Ferner ist die JP H11 356006 A bekannt, in welcher eine Schaltung für einen Motor beschrieben ist, welche in einem Motorgehäuse angeordnet ist. Eine Trägerplatte und ein Schaltelement sind zu einem Schaltmodul verbunden. Das Schaltmodul ist in eine dichtende Masse eingebettet.

Darüber hinaus zeigt die EP 3 007 330 A2 einen Gleichstrommotor mit einer Trägerplatte, welche innerhalb eines Gehäuses angeordnet ist. Auf der Trägerplatte ist ein Bestückungselement vorgesehen, auf welchem ein Elastikelement angeordnet ist. Das Elastikelement ist zwischen der Trägerplatte und einem Gehäusedeckel im Bereich eines Elektronikraums vorgesehen.

Der Erfindung liegt die Aufgabe zugrunde, ein gegenüber dem Stand der Technik weiterentwickeltes Gehäuse anzugeben.

Erfindungsgemäß wird diese Aufgabe gelöst mit einem Gehäuse der eingangs genannten Art,
bei dem die Kühlvorrichtung umlaufend auf einer Trägerplatte angeordnet ist,
bei dem die Kühlvorrichtung einen mit dem Gehäuse verbundenen Wärmeleitring kontaktiert, und
bei dem die Trägerplatte sowie auf dieser angeordnete Komponenten eine Vibrationsdämpfung und eine elektrisch Isolation aufweisen.

Die umlaufende Anordnung der Kühlvorrichtung auf der Trägerplatte bewirkt eine große Fläche bzw. ein großes Volumen, über die bzw. über das Wärme von der Trägerplatte an eine Umgebung abgegeben werden kann. Weiterhin wird dadurch eine besonders kompakte und platzsparende Anordnung erzielt.

Das ist für Anwendungen im Kraftfahrzeugbereich sowie insbesondere für einen Einsatz der Kühlvorrichtung in dem Gehäuse der elektrischen Maschine hilfreich.

Beispielsweise kann die Kühlvorrichtung kreisringförmig ausgeführt sein. Dadurch wird der Vorteil erzielt, dass der innerhalb der Kühlvorrichtung verfügbare Platz auf der Trägerplatte für Bestückungselemente genutzt werden kann. Beispielsweise kann innerhalb der Kühlvorrichtung ein Rotationssensor angeordnet sein, der mit einem stirnseitig auf einer unter der Trägerplatte rotierenden Welle angeordneten Magneten zusammenwirkt.

Der Kontakt der Kühlvorrichtung mit einem mit dem Gehäuse verbundenen Wärmeleitring bewirkt eine Wärmeableitung von der Trägerplatte entlang des Wärmeleitrings über das Gehäuse an eine Umgebung. Beispielsweise kann der Wärmeleitring an einer inneren Mantelfläche des zylindrisch ausgeführten Gehäuses angeordnet sein, wodurch eine Wärmeableitung über die Mantelfläche des Gehäuses erzielt wird. Im Bereich innerhalb des Wärmeleitrings können Komponenten der elektrischen Maschine angeordnet sein, wie beispielsweise Sensoren, Wellen, Isolationskörper etc.

Durch die umlaufende Ausführung der Kühlvorrichtung und des Wärmeleitrings wird eine kompakte, platzsparende Anordnung bei gleichzeitig effektiver Wärmeableitung aus dem Gehäuse erzielt.

Weiterhin bewirkt die Vibrationsdämpfung einen Schutz der Trägerplatte und der darauf angeordneten Komponenten vor mechanischen Belastungen.

Die Kühlvorrichtung weist beispielsweise galvanisch beschichtete Löcher und metallisierte Flächen auf, die in einer Weise ausgeführt sind, dass Wärme von einer Seite der Trägerplatte auf eine gegenüberliegende Seite der Trägerplatte transportiert wird, wobei die genannten Seiten elektrisch voneinander isoliert sind. Über die elektrische Isolation und eine definierte elektrische Verbindung zwischen der Trägerplatte und dem Wärmeleitring wird eine Elektromagnetische Verträglichkeit (EMV) erzielt.

Es ist günstig, wenn die Trägerplatte auf dem Wärmeleitring gelagert ist.

Durch diese Maßnahme kann auf separate Mittel zur Lagerung der Trägerplatte in dem Gehäuse verzichtet werden. Der Wärmeleitring bewirkt einerseits eine Wärmeabführung aus dem Gehäuse und andererseits fungiert er als Lagersitz für die Trägerplatte. Dadurch ergibt sich in Bezug auf das in dem Gehäuse vorhandene Bauraumbudget eine platzsparende Anordnung.

Eine günstige Lösung wird erzielt, wenn zumindest ein elektrisch isolierendes und vibrationsdämpfendes Elastikelement kraftschlüssig mit der Trägerplatte verbunden ist.

Durch die multifunktionale Eigenschaft des Elastikelements wird die Anzahl der für die elektrische Isolation und zur Vibrationsdämpfung erforderlichen Komponenten reduziert und es wird eine besonders platzsparende Anordnung erzielt.

Eine vorteilhafte Ausgestaltung erhält man, wenn ein auf einem Gehäusedeckel angeordneter Anpressring die Trägerplatte auf den Wärmeleitring presst.

Es ist weiterhin günstig, wenn der Anpressring zugleich als Feder und als Dichtung ausgebildet ist.

Durch diese Maßnahme ergibt sich eine platzsparende Ausnutzung des in dem Gehäuse vorhandenen Bauraumbudgets, da auf separate Dichtmittel zwischen dem Gehäusedeckel und der Trägerplatte verzichtet werden kann.

Eine günstige Lösung ergibt sich, wenn zwischen der Trägerplatte und der elektrischen Maschine ein Isolationskörper vorgesehen ist und wenn der Isolationskörper als Lagersitz für eine Welle ausgebildet ist.

Durch die Ausbildung des Isolationskörpers als Lagersitz wird eine platzsparende Anordnung erzielt. Auf separate Komponenten zur Aufnahme eines Lagers der Welle kann verzichtet werden.

Nachfolgend wird die Erfindung anhand von Ausführungsbeispielen näher erläutert.

Es zeigen beispielhaft:
- Fig. 1:: Einen Schnitt durch die Längsachse eines erfindungsgemäßen Gehäuses und einer elektrischen Maschine, und
- Fig. 2:: Einen Ausschnitt aus einem erfindungsgemäßen Gehäuse mit einem Ausschnitt einer darin angeordneten Trägerplatte.

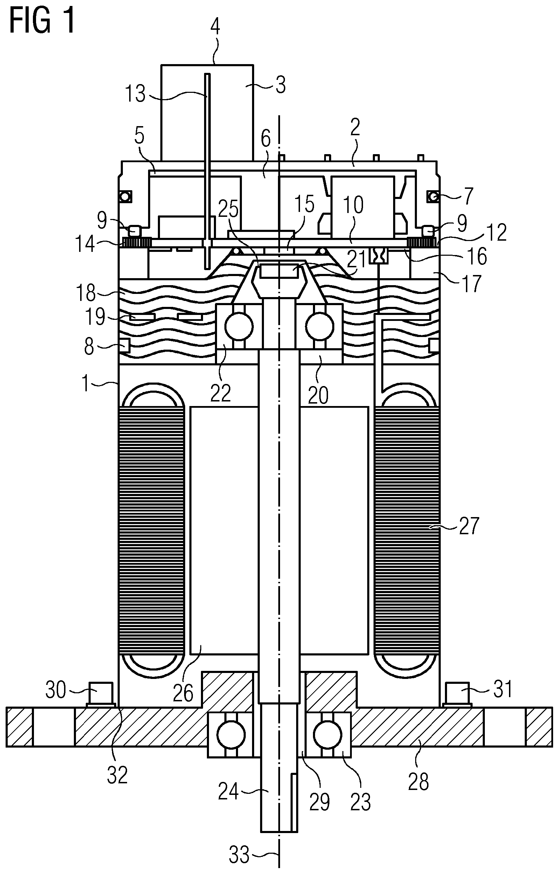

Fig. 1 zeigt eine beispielhafte Ausführungsvariante eines erfindungsgemäßen Gehäuses und einer elektrischen Maschine in geschnittener Darstellung.

Das Gehäuse ist zylindrisch ausgeführt und umfasst einen Gehäusemantel 1 sowie einen in den Gehäusemantel 1 formschlüssig eingesetzten Gehäusedeckel 2. Der Gehäusedeckel 2 weist einen Steckerkörper 3 mit einer ovalen Grundfläche und einer Gehäuseöffnung 4 auf. Erfindungsgemäß sind auch andere als ovale Grundflächen des Steckerkörpers 3 vorstellbar.

Zwischen dem Gehäusedeckel 2 und dem Gehäusemantel 1 ist ein erster Dichtring 7 angeordnet. Über die Gehäuseöffnung 4 ist ein Steckverbinder 13 in das Gehäuse eingeführt und mit einer zylindrischen Trägerplatte 10 verbunden. Die Trägerplatte 10 grenzt mit ihrer Mantelfläche an eine innere Mantelfläche des Gehäusemantels 1 und wird über den Steckverbinder 13 mit Energie versorgt.

Es sind zwei elektrisch isolierende und vibrationsdämpfende Elastikelemente vorgesehen, die kraftschlüssig mit der Trägerplatte 10 verbunden sind: Ein Innenteil 5 und ein Anpressring 9.

Mit dem Gehäusedeckel 2 formschlüssig verbunden ist das freigeformte Innenteil 5 aus Silikon mit einem zylindrischen Kontaktelement 6. Das Kontaktelement 6 ist entlang einer Längsachse 33 ausgerichtet und drückt auf die Trägerplatte 10. Erfindungsgemäß sind auch Ausführungen des Innenteils 5 mit mehr als einem Kontaktelement 6 denkbar.

Weiterhin ist stirnseitig auf dem Gehäusedeckel 2 der aus Silikon ausgeführte Anpressring 9 vorgesehen, der auf die Trägerplatte 10 drückt und aufgrund seiner federnden Eigenschaft eine Federkraft auf die Trägerplatte 10 erzeugt. Der Anpressring 9 weist darüber hinaus eine dichtende Funktion auf. Er ist als einteiliger Ring ausgeführt. Erfindungsgemäß sind jedoch auch Ausführungen mit mehrteiligen Anpressringen 9 vorstellbar.

Das Innenteil 5 und der Anpressring 9 bewirken eine Vibrationsdämpfung und somit eine mechanische Entkopplung der Trägerplatte 10.

Die Trägerplatte 10 umfasst auf ihrer Grund- und ihrer Deckfläche Bestückungselemente, welche Verlustwärme erzeugen. Es sind ein erster Transistor 16, weitere Transistoren sowie ein als aus dem Stand der Technik bekannter, magnetischer Rotationsensor ausgeführter Sensor 15 auf der Trägerplatte 10 vorgesehen. In einem äußeren Bereich der Trägerplatte 10 ist eine raster- und kreisringförmig umlaufend ausgeführte Kühlvorrichtung 14 ausgebildet, welche galvanisch beschichtete Sacklöcher, vergrabene Löcher und metallisierte Flächen aufweist. Diese bewirken einen vorteilhaften Wärmetransport von den Verlustwärme erzeugenden Bestückungselementen zu einem Wärmeleitring 17. Die Ausgestaltung der metallisierten Sacklöcher bewirkt darüber hinaus eine elektrische Isolierung der Kühlvorrichtung 14 von dem Wärmeleitring 17.

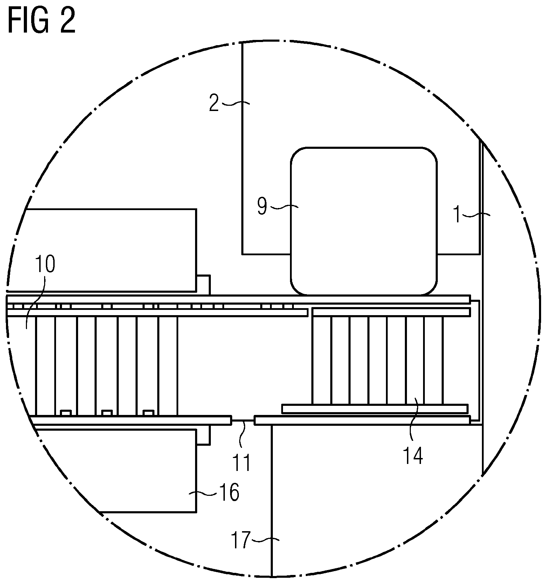

Über eine in Fig. 2 gezeigte Isolationsbarriere 11 und eine Schirmanbindung 12 wird eine definierte Kontaktierung der Trägerplatte 10 mit dem Wärmeleitring 17 erzeugt.

Die Trägerplatte 10 liegt im Bereich der Kühlvorrichtung 14 auf dem mit dem Gehäusemantel 1 verbundenen Wärmeleitring 17, der in Aluminium ausgeführt ist, auf. Das Kontaktelement 6 und der Anpressring 9, der die Trägerplatte 10 im Bereich der Kühlvorrichtung 14 kontaktiert, pressen die Trägerplatte 10 gegen den Wärmeleitring 17, wodurch eine besonders effektive Ableitung von Wärme von den Bestückungselementen der Trägerplatte 10 über die Kühlvorrichtung 14 und den Wärmeleitring 17 in das Gehäuse und von dort in eine Umgebung erzielt wird.

Die Trägerplatte 10 ist zwischen dem Anpressring 9 und dem Wärmeleitring 17 eingeklemmt.

Unter der Trägerplatte 10 und in einem unteren Bereich an den Wärmeleitring 17 angrenzend ist ein elektrisch nichtleitender zylindrischer Isolationskörper 18 mit dem Gehäusemantel 1 verbunden. Eine Mantelfläche des Isolationskörpers 18 grenzt an die innere Mantelfläche des Gehäusemantels 1. Zwischen dem Isolationskörper 18 und dem Gehäusemantel 1 ist ein zweiter Dichtring 8 angeordnet.

In den Isolationskörper 18 ist ein Verschaltegitter 19 eingebettet, welches Pole der als 3-Phasen-Drehstrommotor ausgeführten elektrischen Maschine verschaltet.

Der Isolationskörper 18 weist in einem mittleren Bereich eine Ausnehmung 20 auf, in der ein als Kugellager ausgeführtes erstes Lager 22 angeordnet ist. In dem ersten Lager 22 ist eine Welle 24 gelagert.

Die Welle 24 ist entlang der Längsachse 33 und um diese herum ausgerichtet. Auf einer Stirnseite 25 der Welle 24 ist ein Magnet 21 angeordnet.

Zwischen dem Isolationskörper 18 und der Trägerplatte 10 sowie innerhalb des Wärmeleitrings 17 ist der Sensor 15 vorgesehen. Dieser wirkt über ein den Isolationskörper 18 durchdringendes magnetisches Feld mit dem Magnet 21 in einer Weise zusammen, dass Drehwinkel der Welle 24 gemessen werden.

In Bezug auf die Darstellung in Fig. 1 unterhalb des Isolationskörpers 18 und um die Welle 24 herum ist ein zylindrischer Rotor 26 der elektrischen Maschine angeordnet sowie um den Rotor 26 ein zylindrischer Stator 27. Der Stator 27 grenzt mit seiner äußeren Mantelfläche an die innere Mantelfläche des Gehäusemantels 1 und ist mit dem Isolationskörper 18 elektrisch verbunden. Der Rotor 26 und der Stator 27 sind aus dem Stand der Technik bekannt.

Bezüglich der Darstellung in Fig. 1 unter dem Rotor 26 und dem Stator 27 ist eine Flanschplatte 28 angeordnet, die das Gehäuse stirnseitig abschließt. Die Flanschplatte 28 ist mit dem Gehäusemantel 1 über eine Schweißnaht 32 verbunden. Weiterhin ist der Gehäusemantel 1 über eine erste Schraubenverbindung 30, eine zweite Schraubenverbindung 31 sowie weitere Schraubenverbindungen in einem flanschförmigen Bereich des Gehäusemantels 1 mit dem Gehäusemantel 1 verschraubt. Die erste Schraubenverbindung 30, die zweite Schraubenverbindung 31 und die weiteren Schraubenverbindungen verlaufen parallel zu der Längsachse 33.

In einem mittleren Bereich der Flanschplatte 28 ist eine Bohrung 29 ausgebildet, in welcher die Welle 24 aus dem Gehäuse heraus verläuft. Weiterhin ist mit der Flanschplatte 28 ein als Kugellager ausgeführtes zweites Lager 23 verbunden, in dem die Welle 24 gelagert ist.

Über die Flanschplatte 28 wird eine Wärmeableitung in die Umgebung erzielt.

Fig. 2 zeigt einen Ausschnitt aus einem erfindungsgemäßen Gehäuse mit einem Ausschnitt einer in dem Gehäuse angeordneten Trägerplatte 10, auf der ein erster Transistor 16 sowie weitere Bestückungselemente angeordnet sind. Das konstruktive Prinzip entspricht der in Fig. 1 dargestellten Ausführungsvariante, es werden daher die gleichen Bezugszeichen wie in Fig. 1 verwendet.

Die Trägerplatte 10 ist zylindrisch ausgeführt und grenzt mit ihrer Mantelfläche an eine innere Mantelfläche eines zylindrischen Gehäusemantels 1. In den Gehäusemantel 1 eingeführt ist ein zylindrischer Gehäusedeckel 2, der mit seiner Mantelfläche an die innere Mantelfläche des Gehäusemantels 1 angrenzt. Auf dem Gehäusedeckel 2 ist stirnseitig ein Anpressring 9 angeordnet, der im Bereich ihrer Deckfläche auf die Trägerplatte 10 drückt.

Die Trägerplatte 10 liegt über ihre Grundfläche auf einem zylindrischen Wärmeleitring 17 auf, der über seine äußere Mantelfläche und die innere Mantelfläche des Gehäusemantels 1 mit dem Gehäusemantel 1 verbunden ist.

Die Trägerplatte 10 weist, wie im Zusammenhang mit Fig. 1 beschrieben, eine kreisringförmige Kühlvorrichtung 14 sowie eine elektrische Isolationsbarriere 11 auf. Der Anpressring 9 und der Wärmeleitring 17 berühren die Trägerplatte 10 im Bereich dieser Kühlvorrichtung 14 bzw. klemmen die Trägerplatte 10 ein. Dadurch ergibt sich eine günstige Wärmeableitung von den Bestückungselementen der Trägerplatte 10 über die Trägerplatte 10, die Kühlvorrichtung 14 und den Wärmeleitring 17 an das Gehäuse und von dort in eine Umgebung.

Die Kühlvorrichtung 14 weist für diesen Wärmetransport galvanisch beschichtete Löcher und metallisierte Flächen auf. Sie sind in einer Weise ausgeführt, dass Wärme von einer Seite (z.B. einer Oberseite) der Trägerplatte 10 auf eine gegenüberliegende Seite (z.B. eine Unterseite) der Trägerplatte 10 geleitet wird, ohne die genannten Seiten elektrisch zu verbinden.

### Liste der Bezeichnungen

- 1: Gehäusemantel
- 2: Gehäusedeckel
- 3: Steckerkörper
- 4: Gehäuseöffnung
- 5: Innenteil
- 6: Kontaktelement
- 7: Erster Dichtring
- 8: Zweiter Dichtring
- 9: Anpressring
- 10: Trägerplatte
- 11: Isolationsbarriere
- 12: Schirmanbindung
- 13: Steckverbinder
- 14: Kühlvorrichtung
- 15: Sensor
- 16: Erster Transistor
- 17: Wärmeleitring
- 18: Isolationskörper
- 19: Verschaltegitter
- 20: Ausnehmung
- 21: Magnet
- 22: Erstes Lager
- 23: Zweites Lager
- 24: Welle
- 25: Stirnseite
- 26: Rotor
- 27: Stator
- 28: Flanschplatte
- 29: Bohrung
- 30: Erste Schraubenverbindung
- 31: Zweite Schraubenverbindung
- 32: Schweißnaht
- 33: Längsachse

## Patentansprüche

1. Gehäuse für eine elektrische Maschine, wobei das Gehäuse mit einer Kühlvorrichtung, einer zylindrischen Trägerplatte (10) und einem zylindrischen Wärmeleitring (17) ausgestattet ist, wobei das Gehäuse zylindrisch ausgeführt ist und einen Gehäusemantel (1) sowie einen in den Gehäusemantel (1) von der axialen Seite formschlüssig eingesetzten zylindrischen Gehäusedeckel (2) umfasst,
wobei die Kühlvorrichtung (14) in einem radial äußeren Bereich der Trägerplatte (10) umlaufend auf der Trägerplatte (10) angeordnet ist,
wobei die Trägerplatte (10) sowie auf dieser angeordnete Komponenten eine Vibrationsdämpfung und eine elektrische Isolation aufweisen, wobei mit dem Gehäusedeckel (2) innerhalb des Gehäusedeckels (2) ein Innenteil (5) formschlüssig verbunden ist, wobei auf dem Gehäusedeckel (2) ein Anpressring (9) vorgesehen ist, und
wobei das Innenteil (5) sowie der Anpressring (9) als Elastikelemente kraftschlüssig mit der Trägerplatte (10) verbunden sind, wobei die Kühlvorrichtung (14) und die Trägerplatte (10) zwischen dem Anpressring (9) und dem Wärmeleitring (17) eingeklemmt sind.

2. Gehäuse nach Anspruch 1, **dadurch gekennzeichnet, dass** die Kühlvorrichtung (14) ringförmig ausgebildet ist.

3. Gehäuse nach Anspruch 1 oder 2, **dadurch gekennzeichnet, dass** die Kühlvorrichtung (14) galvanisch beschichtete Löcher und metallisierte Flächen aufweist, die in einer Weise ausgeführt sind, dass Wärme von einer Seite der Trägerplatte (10) auf eine gegenüberliegende Seite der Trägerplatte (10), von Bestückungselementen zu dem Wärmeleitring (17), transportiert wird, wobei die genannten Seiten elektrisch voneinander isoliert sind.

4. Gehäuse nach einem der Ansprüche 1, 2 oder 3, **dadurch gekennzeichnet, dass** die Trägerplatte (10) auf dem Wärmeleitring (17) gelagert ist.

5. Gehäuse nach Anspruch 4, **dadurch gekennzeichnet, dass** der auf dem Gehäusedeckel (2) angeordnete Anpressring (9) die Trägerplatte (10) auf den Wärmeleitring (17) presst.

6. Gehäuse nach Anspruch 5, **dadurch gekennzeichnet, dass** der Anpressring (9) zugleich als Feder und als Dichtung ausgebildet ist.

7. Gehäuse nach einem der Ansprüche 1 bis 6, **dadurch gekennzeichnet, dass** auf der Trägerplatte (10) innerhalb der umlaufenden Kühlvorrichtung (14) ein Sensor (15) angeordnet ist.

8. Gehäuse nach Anspruch 7, **dadurch gekennzeichnet, dass** der Sensor (15) als Rotationssensor ausgebildet ist.

9. Gehäuse nach einem der Ansprüche 1 bis 8, **dadurch gekennzeichnet, dass** zwischen der Trägerplatte (10) und der elektrischen Maschine ein Isolationskörper (18) vorgesehen ist.

10. Gehäuse nach Anspruch 9, **dadurch gekennzeichnet, dass** der Isolationskörper (18) als Lagersitz für eine Welle (24) ausgebildet ist.

11. Gehäuse nach Anspruch 10, **dadurch gekennzeichnet, dass** auf einer Stirnseite (25) der Welle (24) ein mit dem Sensor (15) über ein den Isolationskörper (18) durchdringendes magnetisches Feld zusammenwirkender Magnet (21) angeordnet ist.

## Claims

1. Housing for an electric machine, wherein the housing is equipped with a cooling device, a cylindrical support plate (10) and a cylindrical heat-conducting ring (17), wherein the housing is designed to be cylindrical and comprises a housing shell (1) and a cylindrical housing cover (2) inserted into the housing shell (1) from the axial side in a form-fit manner, wherein
the cooling device (14) is arranged in a radially outer region of the support plate (10) on the periphery of the support plate (10),
wherein the support plate (10) and components arranged thereon are vibration damped and electrically insulated, wherein an inner part (5) is connected in a form-fit manner with the housing cover (2) within the housing cover (2), wherein a press-on ring (9) is provided on the housing cover (2), and wherein the inner part (5) and the press-on ring (9) as elastic elements are connected to the support plate (10) in a force-fit manner, wherein the cooling device (14) and the support plate (10) are clamped between the press-on ring (9) and the heat-conducting ring (17).

2. Housing according to claim 1, **characterised in that** the cooling device (14) is of annular configuration.

3. Housing according to claim 1 or 2, **characterised in that** the cooling device (14) has electroplated holes and metallised surfaces, which are embodied such that heat is transported from one side of the support plate (10) to an opposing side of the support plate (10) by mounting elements to the heat-conducting ring (17), the stated sides being electrically insulated from one another.

4. Housing according to one of claims 1, 2 or 3, **characterised in that** the support plate (10) is mounted on the heat-conducting ring (17).

5. Housing according to claim 4, **characterised in that** the press-on ring (9) arranged on the housing cover (2) presses the support plate (10) onto the heat-conducting ring (17).

6. Housing according to claim 5, **characterised in that** the press-on ring (9) is configured simultaneously as a spring and as a seal.

7. Housing according to one of claims 1 to 6, **characterised in that** a sensor (15) is arranged on the support plate (10) within the peripheral cooling device (14).

8. Housing according to claim 7, **characterised in that** the sensor (15) takes the form of a rotation sensor.

9. Housing according to one of claims 1 to 8, **characterised in that** an insulating body (18) is provided between the support plate (10) and the electric machine.

10. Housing according to claim 9, **characterised in that** the insulating body (18) takes the form of a bearing seat for a shaft (24).

11. Housing according to claim 10, **characterised in that** a magnet (21) cooperating with the sensor (15) via a magnetic field passing through the insulating body (18) is arranged on an end face (25) of the shaft (24).

## Revendications

1. Carter pour machine électrique, le carter étant muni d'un dispositif de refroidissement, d'une plaque de support (10) cylindrique et d'une bague thermoconductrice (17) cylindrique, le carter étant de configuration cylindrique et comportant une enveloppe de carter (1) ainsi qu'un couvercle de carter (2) cylindrique introduit par coopération de formes par la face axiale dans l'enveloppe de carter (1),
dans lequel le dispositif de refroidissement (14) est disposé circonférentiellement sur la plaque de support (10) dans une zone radialement externe de la plaque de support (10),
dans lequel la plaque de support (10) ainsi que les composants disposés sur celle-ci présentent un amortissement des vibrations et une isolation électrique, dans lequel une partie interne (5) est reliée par coopération de formes au couvercle de carter (2) à l'intérieur du couvercle de carter (2), dans lequel une bague de pression (9) est prévue sur le couvercle de carter (2), et dans lequel la partie interne (5) ainsi que la bague de pression (9) sont reliées sous forme d'éléments élastiques par coopération de force à la plaque de support (10), dans lequel le dispositif de refroidissement (14) et la plaque de support (10) sont pincés entre la bague de pression (9) et la bague thermoconductrice (17) .

2. Carter selon la revendication 1, **caractérisé en ce que** le dispositif de refroidissement (14) est de forme annulaire.

3. Carter selon la revendication 1 ou la revendication 2, **caractérisé en ce que** le dispositif de refroidissement (14) comprend des trous revêtus par galvanisation et des surfaces métallisées qui sont réalisés de telle sorte que de la chaleur est transportée depuis une face de la plaque de support (10) sur une face opposée de la plaque de support (10), depuis des éléments de garnissage vers la bague thermoconductrice (17), dans lequel lesdites faces sont isolées électriquement l'une de l'autre.

4. Carter selon l'une des revendications 1, 2 ou 3, **caractérisé en ce que** la plaque de support (10) est montée sur la bague thermoconductrice (17).

5. Carter selon la revendication 4, **caractérisé en ce que** la bague de pression (9) disposée sur le couvercle de carter (2) presse la plaque de support (10) sur la bague thermoconductrice (17).

6. Carter selon la revendication 5, **caractérisé en ce que** la bague de pression (9) se présente en même temps sous forme de ressort et sous forme de joint d'étanchéité.

7. Carter selon l'une des revendications 1 à 6, **caractérisé en ce qu'**un capteur (15) est disposé sur la plaque de support (10) à l'intérieur du dispositif de refroidissement (14) périphérique.

8. Carter selon la revendication 7, **caractérisé en ce que** le capteur (15) se présente sous forme de capteur de rotation.

9. Carter selon l'une des revendications 1 à 8, **caractérisé en ce qu'**un corps isolant (18) est prévu entre la plaque de support (10) et la machine électrique.

10. Carter selon la revendication 9, **caractérisé en ce que** le corps isolant (18) se présente sous forme de siège de palier pour un arbre (24).

11. Carter selon la revendication 10, **caractérisé en ce que** sur une face frontale (25) de l'arbre (24) est disposé un aimant (21) entrant en interaction avec le capteur (15) par l'intermédiaire d'un champ magnétique pénétrant le corps isolant (18).
